**Europäisches Patentamt**

**European Patent Office**

**Office européen des brevets**

(19)

(11) Veröffentlichungsnummer: **0 267 455 B1**

# (12) EUROPÄISCHE PATENTSCHRIFT

(45) Veröffentlichungstag der Patentschrift: **05.02.92**

(21) Anmeldenummer: **87115116.3**

(22) Anmeldetag: **16.10.87**

(51) Int. Cl.5: **H01H 47/04**, H03K 17/30, H03K 3/57, H01F 7/18

(54) **An eine Last angeschalteter Stromstossgenerator.**

(30) Priorität: **28.10.86 CH 4260/86**

(43) Veröffentlichungstag der Anmeldung:
**18.05.88 Patentblatt 88/20**

(45) Bekanntmachung des Hinweises auf die
Patenterteilung:
**05.02.92 Patentblatt 92/06**

(84) Benannte Vertragsstaaten:
**CH DE FR GB IT LI**

(56) Entgegenhaltungen:
| | |
|---|---|
| **DE-A- 3 206 590** | **DE-A- 3 235 851** |
| **DE-A- 3 323 400** | **FR-A- 2 199 612** |
| **GB-A- 2 158 312** | **US-A- 3 105 924** |

(73) Patentinhaber: **EUGEN SEITZ AG**
**Spitalstrasse 204**
**CH-8623 Wetzikon(CH)**

(72) Erfinder: **Widmer, Jörg**
**Glärnischstrasse 6**
**CH-8610 Uster(CH)**
Erfinder: **Kleeli, Rudolf**
**Langfurrenstrasse 56**
**CH-8623 Wetzikon(CH)**

(74) Vertreter: **Patentanwälte Schaad, Balass &**
**Partner**
**Dufourstrasse 101 Postfach**
**CH-8034 Zürich(CH)**

EP 0 267 455 B1

## Beschreibung

Die Erfindung betrifft einen an eine Last ange-schalteten Stromstossgenerator gemäss dem Ober-begriff des Patentanspruches 1.

Solche Stromstossgeneratoren werden insbe-sondere induktiven Lasten, namentlich Elektroma-gneten, vorgeschaltet, bei denen die erforderliche Einschaltleistung erheblich höher ist, als die nach dem Einschalten der Last erforderliche Betriebs- oder Halteleistung. Die Speisequellen für solche Lasten sind nicht immer dazu bemessen, ohne weiteres Einschaltleistungen abzugeben, die das Vielfache der Betriebs- oder Halteleistung betragen.

Ein Stromstossgenerator der eingangs genannten Art ist aus der DE-A 32 06 590 bekannt. Bei diesem Stromstossgenerator ist der erste Festkörperschalter durch einen Thyristor gebildet, der dann gezündet wird, wenn die Spannung, auf die der Kondensator aufgeladen wurde, die Durchbruchspannung von parallel zum Kondensator liegenden Triggerdioden erreicht. Dann entlädt sich der Kondensator über einen Strombegrenzungswiderstand, über eine zum Thyristor hin durchlässige Diode und den Thyristor selbst sowie über die Last, die bei dem bekannten Stromstossgenerator die Spule eines Elektromagnetventils ist. Ein Teil des über der Last entstehenden Spannungsabfalles schaltet den zweiten Festkörperschalter durch, der seinerseits die Sperrung des Transistors des Sperrschwingers und damit die Abschaltung desselben zur Folge hat. Nach der Entladung des Kondensators, der die Einschaltleistung abgegeben hat, wird die Spule über eine Diode und den immer noch leitenden Thyristor direkt von der Speisespannungsquelle mit der Halteleistung versorgt.

Der wesentliche Nachteil des bekannten Stromstossgenerators ist in der Verwendung des Thyristors zu sehen. Hat der Thyristor einmal gezündet, bleibt er auch bei erheblichen Spannungsschwankungen leitend und löscht erst, wenn gar keine Spannung mehr ansteht. Wenn nun aber die Speisespannung aus irgendeinem Grunde ohne auf Null zu gehen soweit absinkt, dass nicht einmal die Halteleistung aufgebracht werden kann, fällt der Elektromagnet ab, während der Thyristor immer noch leitend ist. Beim erneuten Ansteigen der Speisespannung wird aber die Sperrschwingerschaltung nicht wieder eingeschaltet, so dass die Einschaltleistung nicht mehr erbracht werden kann. Der Elektromagnet wird nicht wieder anziehen. Wenn der Elektromagnet zur Betätigung eines Ventiles dient, kann dies fatale Wirkungen haben, denn elektrisch kann die unterbliebene Betätigung des Ventiles nicht festgestellt werden, da der Haltestrom nur durch den abgefallenen Elektromagneten fliesst, aber nicht imstande ist, die erforderliche Einschaltleistung zu bieten.

Es ist daher ein Zweck der Erfindung, einen Stromstossgenerator der eingangs genannten Art zu schaffen, der die beschriebenen Nachteile vermeidet. Zu diesem Zweck weist der vorgeschlagene Stromstossgenerator die im Kennzeichen des Patentanspruches 1 angegebenen Merkmale auf.

Zum Unterschied eines Thyristors schaltet und sperrt der Transistor bei vorbestimmten Spannungen an seiner Basis. Beim Absinken der Speisespannung unter einen bestimmten Wert unterbricht somit der vorzugsweise als pnp-Transistor ausge-bildete, erste Festkörperschalter den Laststrom-kreis, so dass beim Wiederanstieg der Speisespan-nung die Sperrschwingerschaltung selbsttätig wie-der eingeschaltet wird, durch die der Kondensator die zur Abgabe der Einschaltleistung erforderliche Energie in Form der höheren Ladespannung speichert.

Nachstehend ist anhand der Zeichnung ein Ausführungsbeispiel des vorgeschlagenen Stromstossgenerators beschrieben.

Der dargestellte Stromstossgenerator 10 ist über einen Schalter 11 an eine durch die Klemmen 12, 13 angedeutete Gleichspannungsquelle von beispielsweise 12 V anschaltbar. Auf den Schalter 11, der durch ein entfernt vom Stromstossgenerator 10 angeordnetes EIN-AUS-Schaltglied gebildet sein kann, folgen zwei durch die europäische Norm (EN) 50020 für die Kategorie ib vorgeschriebene Sperrdioden 14, 15, welche transiente, von Schaltvorgängen im Stromstossgenerator herrührende Spannungsstösse von der Gleichspannungsquelle fernhalten. Ausserdem ist ein Widerstand 44 parallel zur Gleichspannungsquelle geschaltet, der den Eingangswiderstand der Schaltung verringert und deren Ansprechempfindlichkeit definiert.

Auf die Dioden 14, 15 folgen ein Strombegrenzungswiderstand 16, ein Elektrolytkondensator 20 und ein Keramikkondensator 46, die nach dem Widerstand 16 parallel zur Gleichspannungsquelle 12, 13 liegen. Der Kondensator 20 liefert den Spitzenstrom an einen Uebertrager 17 mit einer Primärwicklung 18 und einer Sekundärwicklung 19. In Reihe mit der einerends an die positive Speiseleitung angeschlossenen Primärwicklung 18 sind zwei Widerstände 21, 22 geschaltet, die einen Spannungsteiler bilden. Der Kondensator 46 leitet transiente Spannungsspitzen ab. Der Abgriff 23 des Spannungsteilers ist an die Basis eines Transistors 24 geführt. Der Kollektor dieses Transistors 24 ist mit der einerends ebenfalls an die positive Speise-leitung angeschlossenen Sekundärwicklung 19 ver-bunden, während der Emitter des Transistors 24 über eine zur negativen Speiseleitung hin leitende Diode 25 an erstere gekoppelt ist.

Die Sekundärwicklung 19 bildet somit zusammen mit dem Transistor 24 und den diesen steuernden Spannungsteiler 21, 22 einen Oszillator bzw. einen Sperrschwinger, dessen Frequenz im Bereich von etwa 40 - 60 kHz liegen kann, wobei wegen der Diode 25 der Strom nur in einer Richtung durch die Sekundärwicklung 19 fliessen kann. Jedesmal, wenn der Stromfluss durch die Wicklung 19 unterbrochen wird, entsteht an dieser durch die darin gespeicherte magnetische Energie ein positiver Spannungsimpuls, der über eine gleichrichtende Diode 26 einem Elektrolytkondensator 27 zugeführt wird. Dieser Vorgang wiederholt sich periodisch mit der Frequenz des Sperrschwingers, so dass der Kondensator über die Diode 26 mit den Ausgangsimpulsen der Sekundärwicklung aufgeladen wird, bis eine vorgegebene Spannung erreicht ist.

Diese vorgegebene Spannung ist bestimmt durch die Durchbruchspannung zweier in Reihe geschalteter Diacs 28, 29, die ihrerseits in Serie mit Widerständen 30, 31, 45, 32 zwischen der positiven Elektrode des Kondensators 27 und der negativen Speiseleitung geschaltet sind. Dabei bilden die Widerstände 31, 45, 32 einen temperaturkompensierten Spannungsteiler, weil der Widerstand 45 ein NTC-Widerstand ist. Der Abgriff 33 dieses Spannungsteilers ist mit der Basis eines Transistors 34 verbunden. Der Emitter dieses Transistors 34 ist mit der negativen Speiseleitung verbunden. Der Kollektor dieses Transistors 34 dagegen ist einerseits über eine zur Basis des Transistors 24 hin sperrende Diode 35 mit dieser Basis verbunden und andererseits über einen Widerstand 36 mit der Basis des Transistors 39.

Sobald der Kondensator 27 auf die Durchbruchspannung der Diacs 28, 29 aufgeladen ist, fliesst durch diese ein Strom, der über die Widerstände 30 bis 32 und 45 einen Spannungsabfall zur Folge hat. Damit wird der Abgriff 33 positiv, was zur Durchschaltung des Transistors 34 führt. Wenn der Transistor 34 leitet, dann geht einerseits das Potential der Basis des Transistors 24 auf Null, so dass dieser sperrt, und andererseits fliesst über die Widerstände 37, 36 ein Strom, so dass das Potential am Schaltpunkt 38 zwischen den Widerständen 37, 36 um den Spannungsabfall über dem Widerstand 37 absinkt. Dieser Schaltpunkt 38 ist mit der Basis eines pnp-Transistors 39 verbunden, der durch das sinkende Potential des Schaltpunktes 38 durchschaltet.

Dieser Transistor 39 ist zwischen die positive Elektrode des Kondensators 27 und dem einen Anschluss 40 einer Spule 41 eines Elektromagnetventiles geschaltet, deren anderer Anschluss 42 an die negative Speiseleitung angeschlossen ist.

Der Kondensator 27 entlädt sich damit über die Spule 41. Nach der Entladung des Kondensators 27 fliesst der Spule 41 Gleichstrom aus der Spannungsquelle 12, 13 über die Sekundärwicklung 19, die Diode 26 und über den Transistor 39 weiter, wobei dieser leitend bleibt, weil über diesen Pfad auch der Basisstrom über den Widerstand 36 und den Transistor 34 fliesst. Dieser bleibt leitend, weil die Widerstände 31, 32 und 45 ausserdem auch parallel zur Spule 41 geschaltet sind, so dass der Abgriff 33 auf einem positiven Potential bleibt.

Sinkt nun die Speisespannung auf einen Wert ab, der nicht mehr ausreicht, um die Halteleistung zu erbringen, sinkt auch der Spannungsabfall über der Spule 41 und damit das Potential am Abgriff 33. Dies hat zur Folge, dass der Transistor 34 wieder sperrt, so dass kein Strom mehr über die Widerstände 37, 36 fliessen kann. Damit erhöht sich aber das Potential am Schaltpunkt 38 und damit an der Basis des Transistors 39, der dann sperrt. Damit ist der Stromfluss durch die Spule 41 unterbunden. Der in der Spule 41 durch die noch gespeicherte magnetische Energie induzierte Strom wird durch eine parallel zur Spule 41 geschaltete Zenerdiode 43 kurzgeschlossen.

Steigt nun die Speisespannung wieder auf ihren Nennwert an, wiederholen sich die vorstehend beschriebenen Vorgänge, so dass der Spule 41 auf alle Fälle wieder die ausreichende Einschaltleistung zugeführt wird. Die Zeitverzögerung zwischen dem Einschalten der Speisespannungsquelle oder im Wiederansteigen der Speisespannung bis zur Abgabe der Einschaltleistung an die Spule 41 beträgt grössenordnungsmässig etwa 0,5 Sekunden. Die Stellung des Ventils kann einwandfrei elektrisch festgestellt werden.

Nachstehend sind rein beispielsweise die Werte einiger Schaltungselemente dargestellten Stromstossgenerators angegeben:
Dioden 14, 15, 35: Je 1 N 4004;
Widerstand 16: 33 Ohm, 1/4 W;
Kondensator 20: 100 Mikrofarad;
Widerstand 21: 8,2 Kiloohm;
Widerstand 22: 1,2 Kiloohm;
Transistoren 24, 34: ZTX 653;
Diode 26: UF 4004;
Kondensator 27: 4,7 Mikrofarad;
Diacs 28, 29: BR 100-03;
Widerstände 31, 36: Je 10 Kiloohm;
Widerstand 30: 1,8 Kiloohm;
Widerstand 37: 2,7 Kiloohm;
Transitor 39: pnp ZTX 753;
Zenerdiode 43: BZX 85 C 75;
Widerstand 44: 150 Ohm;
NTC-Widerstand 45: 4,7 Kiloohm.

Bei dem beschriebenen Stromstossgenerator ist bemerkenswert, dass gewisse Schaltungselemente eine Doppelfunktion ausüben. So ist beispielsweise die Diode 26 der Gleichrichter um den Kondensator 27 aufzuladen, und sodann, wenn dieser entladen ist, der Gleichrichter zur Zuführung der Haltespannung an die Spule 41. Ferner übt der Transistor 34 eine Doppelfuntion insofern aus, als er einerseits zum Ausschalten des Sperrschwingers und andererseits zum Durchschalten des Transistors 39 dient. Das Uebersetzungsverhältnis des Uebertragers 17 bzw. die Durchbruchspannung der Diacs 28, 29 sind so zu wählen, dass die Spannung, auf die der Kondensator 27 aufgeladen wird, etwa das Fünf- bis Zehnfache der an den Klemmen 12, 13 anstehenden Gleichspannung beträgt. Dabei wird der Spannungsquelle 12, 13 ein Strom in der Grössenordnung von 20 mA entnommen.

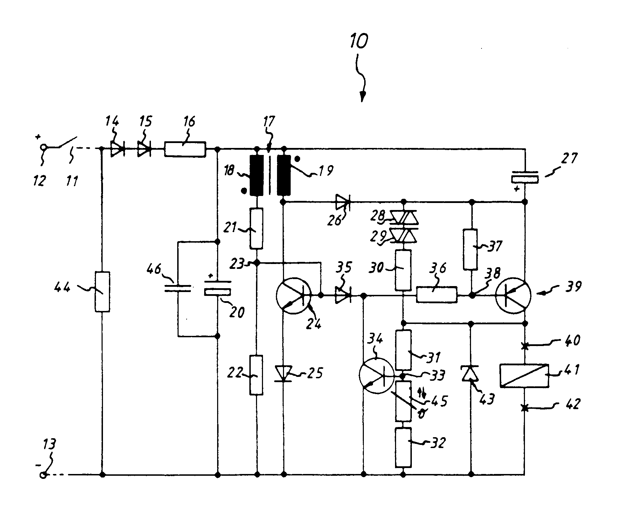

Die gesamte in Fig. 1 gezeigte Schaltung (mit Ausnahme des Schalters 11) kann als kleine gedruckte Schaltung in dem das Elektromagnetventil mit der Spule 41 umgebenden Gehäuse angeordnet werden.

## Patentansprüche

1. An eine Last (41) angeschalteter Stromstossgenerator (10) zur zeitlich begrenzten Abgabe einer erhöhten Einschaltleistung an die Last (41), mit einer an eine Speisespannungsquelle (12, 13) anschaltbaren Sperrschwingerschaltung (21, 22, 19, 24), welche einen Kondensator (27) auf eine gegenüber der Speisespannung höhere Spannung auflädt, bis bei Erreichen eines vorbestimmten Spannungswertes ein erster Festkörperschalter (39) den Kondensator (27) zur Abgabe der Einschaltleistung mit der Last (41) verbindet und gleichzeitig ein von einem parallel zur Last (41) geschalteten Spannungsteiler (31, 45, 32) gesteuerter, durch einen Transistor gebildeter, zweiter Festkörperschalter (34) die Sperrschwingerschaltung (21, 22, 19, 24) ausschaltet, während der Laststromkreis (39, 41) über eine zur Last (41) hin durchlässige Diode (26) an die Speisespannungsquelle (12, 13) gekoppelt ist, dadurch gekennzeichnet, dass der erste Festkörperschalter ein Transistor (39) ist, der durch den zweiten Festkörperschalter (34) getriggert ist.

2. Stromstossgenerator nach Patentanspruch 1, dadurch gekennzeichnet, dass der erste Festkörperschalter ein pnp-Transistor (39) ist.

3. Stromstossgenerator nach Patentanspruch 1, dadurch gekennzeichnet, dass die zur Last hin durchlässige Diode (26) während der Einschaltdauer der Sperrschwingerschaltung (21, 22, 19, 24) den Gleichrichter für den dem Kondensator (27) zugeführten Ladestrom bildet.

4. Stromstossgenerator nach den Patentansprüchen 2 und 3, dadurch gekennzeichnet, dass die Basis des pnp-Transistors (39) mit dem Abgriff (38) eines weiteren Spannungsteilers (37, 36) verbunden ist, der zwischen der Diode (26) und dem weiteren Transistor (34) eingeschaltet ist.

5. Stromstossgenerator nach einem der Patentansprüche 1 bis 4, dadurch gekennzeichnet, dass der Spannungsteiler (31, 45, 32) einen NTC-Widerstand umfasst.

6. Stromstossgenerator nach einem der Patentansprüche 1 bis 4, dadurch gekennzeichnet, dass die Last durch die Spule (41) eines Elektromagnetventiles gebildet ist.

## Claims

1. A current surge generator (10) connected to a load (41) for a time-limited delivery to the load (41) of an increased making capacity, with a blocking oscillator circuit (21, 22, 19, 24) connectable to a supply-voltage source (12, 13), which oscillator circuit charges a capacitor (27) to a voltage higher than that of the supply voltage until a first solid state switch (39) connects the capacitor (27) to the load (41) for delivering the making capacity when a predetermined voltage value has been attained and simultaneously a second solid state switch (34) formed by a transistor, controlled by a voltage divider (31, 45, 32) disposed in parallel to the load (41) cuts off the blocking oscillator circuit (21, 22, 18, 24), while the load current circuit (39, 41) is connected to the supply voltage source (12, 13) via a diode (26) that is conducting towards the load, characterized in that the first solid state switch is a transistor (39) which is triggered by the second solid state switch (34).

2. A current surge generator according to patent claim 1, characterized in that the first solid state switch is a p-n-p transistor (39).

3. A current surge generator according to patent claim 1, characterized in that during the switched-on period of the blocking oscillator circuit (21, 22, 19, 24), the diode (26) which is conducting towards the load forms the rectifier for the load current supplied to the capacitor (27).

4. A current surge generator according to patent claims 2 and 3, characterized in that the base of the p-n-p transistor (39) is connected to the pick-up (38) of a further voltage divider (37, 36) disposed between the diode (26) and the further transistor (34).

**5.** A current surge generator according to one of patent claims 1 to 4, characterized in that the voltage divider (31, 45, 32) comprises an NTC resistor.

**6.** A current surge generator according to one of patent claims 1 to 4, characterized in that the load is formed by the coil (41) of an electromagnetic valve.

**Revendications**

**1.** Générateur d'impulsions de courant (10), branché sur une charge (41), en vue de produire, de façon limitée dans le temps, une puissance de connexion élevée sur la charge (41), avec un oscillateur de blocage (21,22,19,24), susceptible d'être raccordé à une source de tension d'alimentation (12,13), qui charge un condensateur (27) à une tension plus élevée que la tension d'alimentation, jusqu'à ce qu'une fois atteinte une valeur de tension prédéterminée, un premier interrupteur à état solide (39) relie le condensateur (27) à la charge (41), en vue de fournir la puissance de connexion, et, simultanément, un deuxième interrupteur à état solide (34), commandé par un diviseur de tension (31,45,32), mis en parallèle avec la charge (41), mette hors circuit l'oscillateur de blocage (21,22,19,24), tandis que le circuit de charge (39,41) est couplé à la source de tension d'alimentation (12,13) par l'intermédiaire d'une diode (26) passante vers la charge (41), caractérisé en ce que le premier interrupteur à état solide est un transistor (39), qui est commandé par le deuxième interrupteur à état solide (34).

**2.** Générateur d'impulsions de courant selon la revendication 1, caractérisé en ce que le premier interrupteur à état solide est un transistor pnp (39).

**3.** Générateur d'impulsions de courant selon la revendication 1, caractérisé en ce que la diode (36) passante vers la charge forme pendant la durée de connexion de l'oscillateur de blocage (21,22,19,24) le redresseur pour le courant de charge amené au condensateur (27).

**4.** Générateur d'impulsions de courant selon les revendications 2 et 3, caractérisé en ce que la base du transistor pnp (39) est reliée au point de prélèvement (38) d'un autre diviseur de tension (37,36), mis en circuit entre la diode (36) et l'autre transistor (34).

**5.** Générateur d'impulsions de courant selon l'une des revendications 1 à 4, caractérisé en ce que le diviseur de tension (31,45,32) comprend une résistance à coefficient de température négatif.

**6.** Générateur d'impulsions de courant selon l'une des revendications 1 à 4, caractérisé en ce que la charge est formée par la bobine (41) d'une électrovanne.